# EUROPEAN PATENT APPLICATION

(11) **EP 1 215 779 A2**
(43) Date of publication of application: **19.06.2002**
(21) Application number: 01127317.4
(22) Date of filing: 19.11.2001
(51) Int. Cl.: H01S 5/223, H01S 5/02

(54) **Semiconductor laser, method for fabricating thereof, and method for mounting thereof**

(30) Priority: 30.11.2000 JP 2000364491
(71) Applicant: Kabushiki Kaisha Toshiba, Tokyo 105-8001 (JP)
(72) Inventor: Shinozawa, Hideo, Yokohama-shi, Kanagawa 221-0013 (JP); Yamamoto, Yoshio, Kawasaki-shi, Kanagawa 213-0001 (JP); Nonomura, Toshiyuki, Kawasaki-shi, Kanagawa 212-0016 (JP); Fukuoka, Kazuo, Yokohama-shi, Kanagawa 247-0006 (JP)
(74) Representative: HOFFMANN - EITLE

(57) **Abstract**

Inhibiting an reflective coating of a semiconductor laser from peeling. In addition to a p-InGaAlP ridge-stripe optical waveguide layer 6, a p-InGaAlP ridge-stripe 6a is formed on a p-InGaP etching stopper layer 5. Thereby, non-optical-waveguide swellings 13a are formed on both sides of an optical waveguide swelling 13.

## Description

### Crossreference to Related Applications

This application is based upon and claims the benefit of priority from the Japanese Patent Application No. 2000-364491 filed on November 30, 2000; the entire contents of which are incorporated herein by reference.

### Field of the Invention

The present invention relates to a semiconductor laser, a fabricating method thereof, and a mounting method thereof, and is particularly suitably applicable in a semiconductor laser having a ridge-stripe structure.

### Description of the Related Art

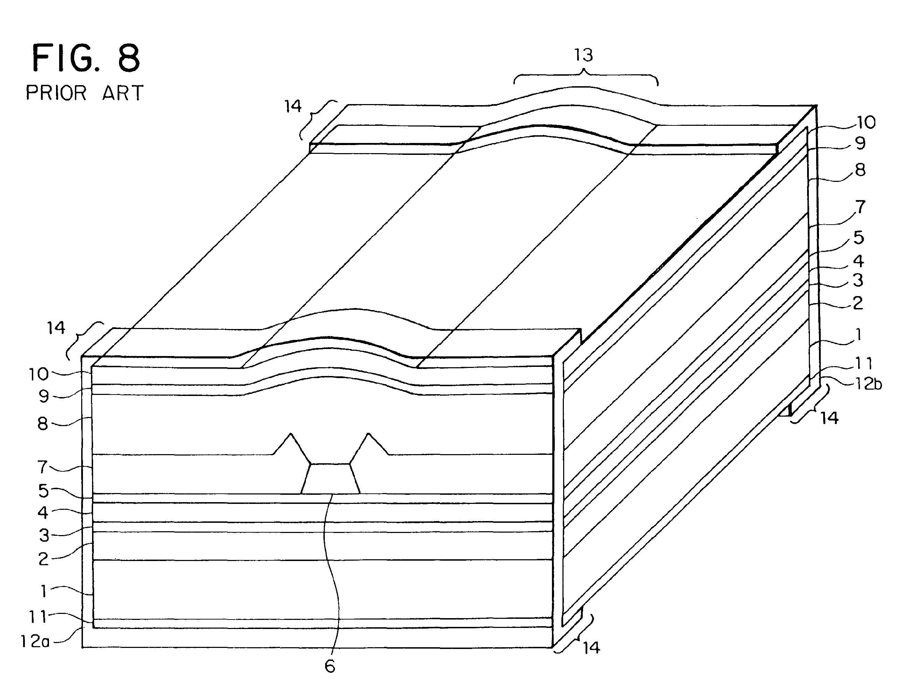

Fig. 8 is a perspective view showing a rough configuration of an existing 650 nm semiconductor laser. In Fig. 8, an n-InGaAlP cladding layer 2, an InGaAlP MQW (multiple quantum well) active layer 3, a p-InGaAlP cladding layer 4, and a p-InGaP etching stopper layer 5 are stacked in turn on an n-GaAs substrate 1. Further, a p-InGaAlP ridge-stripe optical waveguide layer 6 is formed on the p-InGaP etching stopper layer 5. N-GaAs current blocking layers 7 are formed on both sides of the p-InGaAlP ridge-stripe optical waveguide layer 6, and, a p-GaAs contact layer 8 is formed on the p-InGaAlP ridge-stripe optical waveguide 6 and the n-GaAs current blocking layers 7.

Furthermore, a p-side electrode 9 and a solder layer 10 are formed on the p-GaAs contact layer 8, and, an n-side electrode 11 is formed on a rear surface of the n-GaAs substrate 1. An optical waveguide swelling 13, corresponding to the p-InGaAlP ridge-stripe optical waveguide layer 6, is generated on a laser stripe surface (a surface opposite to the substrate 1) where the solder layer 10 is formed.

Furthermore, a front reflective coating 12a and a rear reflective coating 12b are formed on end faces of a resonator. Since these front and rear reflective coatings 12a and 12b go around also on top and bottom chip surfaces, there are formed reflective coating extensions 14 of a length of approximately ten and several micrometers.

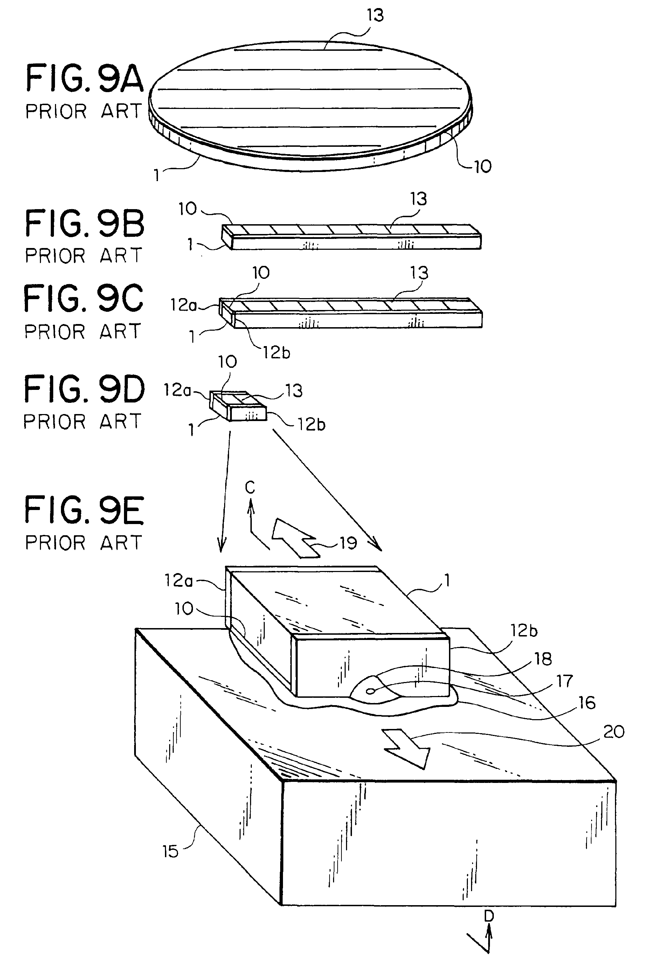

Figs. 9A through 9E are perspective views showing the sequence of a formation process of the reflective coatings of an existing semiconductor laser and a mounting process thereof. When the solder layer 10 is formed on a wafer-like substrate 1, as shown in Fig. 9A, the wafer-like substrate 1 is cleaved, as shown in Fig. 9B. Thereby, the wafer-like substrate 1 is cut into bars, and a resonator surface is formed on a cleaved facet.

Next, cleaved bar-like substrates 1 are piled up/down, followed by sputtering on the cleaved facets. Thus, the front and rear reflective coatings 12a and 12b are formed on the cleaved facets, as shown in Fig. 9C. At the sputtering, since the front and rear reflective coatings 12a and 12b, while going around to the top and bottom surfaces of the bar-like substrate 1, are formed, the reflective coating extensions 14 are formed on the top and bottom surfaces of the bar-like substrate 1.

Next, the bar-like substrate 1 is scribed, and thereby, the bar-like substrate 1 is cut into chips, as shown in Fig. 9D.

Next, the semiconductor chip, with the laser stripe surface thereof directed downward, is mounted on a heat sink 15, as shown in Fig. 9E. Then, the semiconductor chip is heated while pressing it with a collet. Thereby, the semiconductor chip is soldered through the solder layer 10 onto the heat sink 15.

However, in the existing fabricating method of the semiconductor laser, when the laser chip is mounted on the heat sink 15 with the laser-stripe surface thereof directed downward, compressive stress on the rear reflective coating 12b concentrates in the neighborhood of the optical waveguide swelling 13. As a result, there occur problems that peeling 18 of the reflective coating 12b is generated in the neighborhood of an emitting point 17.

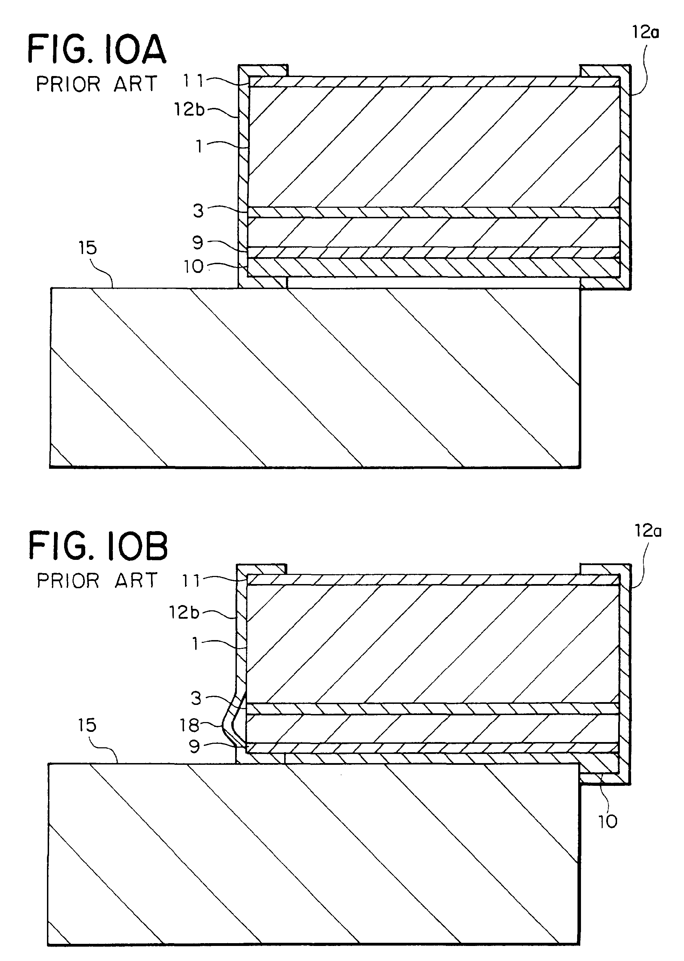

Figs. 10A and 10B are diagrams for explaining a mechanism of generation of the peeling 18, which are sectional views, cut along a C-D line in Fig. 9E, showing states before and after the soldering.

In Figs. 10A and 10B, when the semiconductor chip is soldered under heating and pressurizing, the solder layer 10 is melted and flows outside, and the rear reflective coating 12b suffers compressive stress through the reflective coating extension 14. Since the optical waveguide swelling 13 in the neighborhood of an emitting point 17 is higher than other portion on the laser stripe surface, the compressive stress concentrates on the optical waveguide swelling 13. Accordingly, shearing stress is generated between the rear reflective coating 12b in the neighborhood of the emitting point 17 and the cleaved facet, and the peeling 18 of the reflective coating 12b occurs in the neighborhood of the emitting point 17. When the peeling 18 of the reflective coating 12b occurs, reflectance at the emitting point 17 varies. Backward exit light 20 emitted through the reflective coating 12b is usually used as monitoring light. When the output of the monitoring light varies, monitoring signal intensity failure is caused, and fabrication yield is deteriorated.

Furthermore, when the peeling 18 of the reflective coating 12b occurs, the cleaved facet tends to be easily corroded, and reliability of the semiconductor laser is deteriorated.

Accordingly the object of the present invention is to provide a semiconductor laser capable of suppressing the peeling of the reflective coating, a fabricating method thereof, and a mounting method thereof.

### Summary

A semiconductor laser according to an embodiment of the present invention includes a laser stripe portion, a first site having a shape swelling on the laser stripe portion, and a second site, disposed in the surroundings of the first site, having a shape swelling higher than the first site.

A semiconductor laser according to another embodiment of the present invention is one that includes a substrate, a surface on a side opposite to the substrate, a laser-stripe portion formed on the substrate, resonator surfaces formed on both ends of the laser-stripe portion, and a site, disposed in the neighborhood of at least one of the resonator surfaces, swelling up to a higher portion than a height of the surface on the side opposite to the substrate which surface is an upper portion of the laser-stripe portion.

A semiconductor laser according to still another embodiment of the present invention includes a first conductivity type substrate, a first conductivity type cladding layer formed on the first conductivity type substrate, an active layer formed on the first conductivity type cladding layer, a second conductivity type cladding layer formed on the active layer, a second conductivity type ridge-stripe optical waveguide formed on the second conductivity type cladding layer, and a second conductivity type protrusion formed on the second conductivity type cladding layer and disposed in a region other than the second conductivity type ridge-stripe optical waveguide.

A fabricating method of a semiconductor laser according to an embodiment of the present invention includes forming a first conductivity type cladding layer on a first conductivity type substrate, forming an active layer on the first conductivity type cladding layer, forming a second conductivity type cladding layer on the active layer, forming a second conductivity type semiconductor layer on the second conductivity type cladding layer, forming a dielectrics film on the second conductivity type semiconductor layer by patterning, forming a second conductivity type ridge-stripe optical waveguide and a second conductivity type protrusion on the second conductivity type cladding layer by etching the second conductivity type semiconductor layer with the patterned dielectrics film as a mask, removing one that is the patterned dielectrics film and formed on the second conductivity type protrusion, stacking a first conductivity type semiconductor layer, with one that is the patterned dielectrics film and formed on the second conductivity type ridge-stripe optical waveguide as a mask, and stacking a second conductivity type contact layer after removal of the dielectrics film formed on the second conductivity type ridge-stripe optical waveguide.

A method for mounting a semiconductor laser according to an embodiment of the present invention is a method for mounting a semiconductor laser that includes a substrate; a surface on a side opposite to the substrate; a laser-stripe portion formed on the substrate; resonator surfaces formed on both ends of the laser-stripe portion; and a site that is disposed in the neighborhood of at least one of the resonator surfaces and swells up to a portion higher than a height of the surface on the side opposite to the substrate which surface is an upper portion of the laser-stripe portion, on a laser chip mounting surface, the method including positioning the surface on the side opposite to the substrate facing to the laser chip mounting surface, and fixing the positioned state.

### Brief Description of the Drawings

The invention is described with reference to the drawings, which are presented for the purpose of illustration only and are in no way limiting of the invention.

Fig. 1 is a perspective view showing a rough configuration of a semiconductor laser according to a first embodiment of the present invention.

Figs. 2A, 2B, 2C, 2D, and 2E are perspective views showing the sequence of a mounting process of the semiconductor laser according to the first embodiment of the present invention.

Figs. 3A, 3B, and 3C are sectional views showing the sequence of a fabricating process of the semiconductor laser according to the first embodiment of the present invention.

Figs. 4A and 4B, continuations of Figs. 3A, 3B, and 3C, are sectional views showing the sequence of a fabricating process of the semiconductor laser according to the first embodiment of the present invention.

Fig. 5A is a perspective view showing a rough configuration of a semiconductor laser according to a second embodiment of the present invention; Fig.5B is a perspective view showing a rough configuration of a semiconductor laser according to a third embodiment of the present invention.

Fig.6 is a perspective view showing a rough configuration of a semiconductor laser according to a fourth embodiment of the present invention.

Fig. 7 is a sectional view cut along an A-B line in Fig. 6.

Fig. 8 is a perspective view showing a rough configuration of an existing semiconductor laser.

Figs. 9A, 9B, 9C, 9D, and 9E are perspective views showing the sequence of a formation process of an reflective coating and a mounting process of an existing semiconductor laser.

Figs. 10A and 10B are sectional views, cut along a C-D line in Fig. 9E, showing states before and after soldering.

### Detailed Description

### (Explanation of Embodiments)

According to the present invention, stress on protecting films at both ends of a laser-stripe portion may be suppressed, and the face protecting films may be inhibited from peeling.

That is, according to one embodiment, even when a laser chip is mounted on a heatsink with a laser-stripe surface directed downward, the laser-stripe surface, positioned downward the laser-stripe portion, may be made not to come into contact with a heatsink. As a result, an reflective coating in the neighborhood of the laser-stripe portion may be inhibited from peeling.

According to another embodiment, even when the laser chip is mounted on the heatsink with the laser-stripe surface directed downward, the laser chip is held on the heatsink so that the laser-stripe surface, positioned downward the laser-stripe portion, may be made not to come into contact with the heatsink. As a result, stress on the protecting films at the both ends of the laser-stripe portion may be suppressed.

According to still another embodiment, also when there is a swelling in an ridge-stripe optical waveguide portion, a swelling larger than a ridge-stripe optical waveguide swelling may be formed in a region other than the ridge-stripe optical waveguide, without forming a new surface for stacking. Accordingly, even when the laser chip is mounted with the ridge-stripe optical waveguide portion directed downward, the swelling of the ridge-stripe optical waveguide portion is made not to come into contact with a heatsink. As a result, an reflective coating in the neighborhood of an emitting point may be inhibited from peeling.

Furthermore, according to a fabricating method of a semiconductor laser according to one embodiment of the present invention, a swelling larger than the swelling formed in the ridge-stripe optical waveguide portion may be formed in a region other than the ridge-stripe optical waveguide portion, by changing only a patterning in the formation of the ridge-stripe optical waveguide. Accordingly, the ridge-stripe optical waveguide portion is made not to come into contact with the heatsink, without newly forming a new stacking layer or adding a new etching process.

Still furthermore, according to a mounting method of a semiconductor laser according to an embodiment of the present invention, even when the laser chip is mounted on the heatsink with the laser-stripe surface directed downward, the protecting films at the both ends of the laser-stripe portion may be suppressed from suffering stress, and, thereby, the reflective coating may be inhibited from peeling.

As an implementation mode of the present invention, the second conductivity type protrusion is a second conductivity type ridge-stripe disposed in parallel with the second conductivity type ridge-stripe optical waveguide. Thereby, even when the swelling in the ridge-stripe optical waveguide portion is mounted so as not to come into contact with the heatsink, the laser chip may be stably mounted on the heatsink, while securing heat dissipation properties. The second conductivity type protrusion may be formed with a stripe-length shorter than that of the second conductivity type ridge-stripe optical waveguide.

Furthermore, a semiconductor laser according to one implementation mode of the present invention further includes a first conductivity type current blocking layer, which is formed on the second conductivity type cladding layer so as to cover the second conductivity type protrusion and disposed in a region other than the second conductivity type ridge-stripe optical waveguide. Thereby, a current may be efficiently flowed to an emitting portion, and a threshold current may be reduced.

Still furthermore, a semiconductor laser according to one implementation mode of the present invention further includes a front reflective coating for protecting at least one end of the second conductive ridge-stripe optical waveguide, and a rear reflective coating that protects at least the other end of the second conductive ridge-stripe optical waveguide and is higher in reflectance than the front reflective coating. Thereby, exit light may be efficiently taken out, and light power may be easily increased.

Furthermore, as one implementation mode of the present invention, the first conductivity type substrate is made of GaAs, the cladding layer is made of InGaAlP, and the active layer has an InGaAlP system multiple quantum well structure. Thereby, 650 nm laser light, while suppressing an increase in the threshold current, may be efficiently obtained.

In the following, the semiconductor lasers according to the aforementioned embodiments will be explained with reference to drawings.

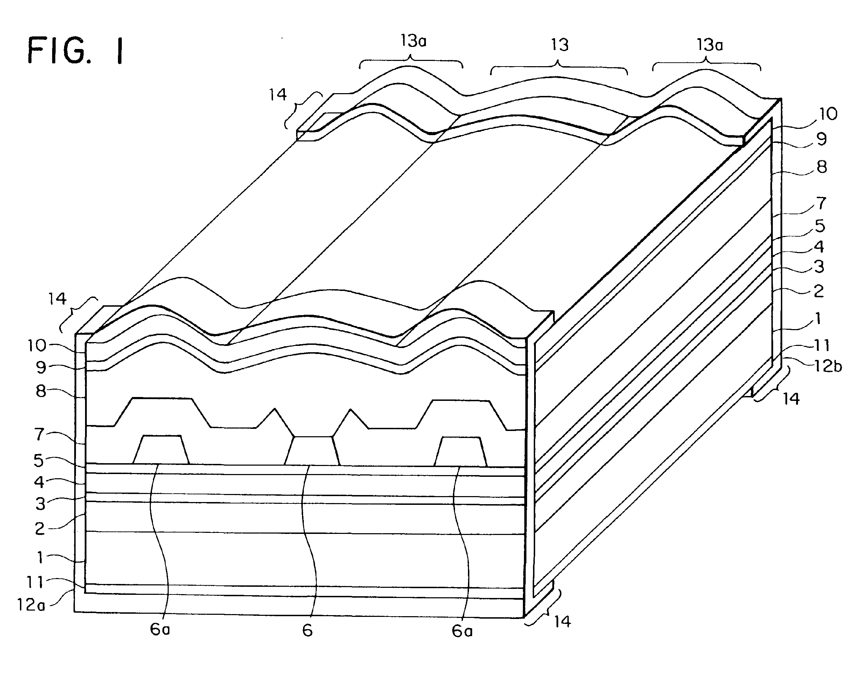

Fig. 1 is a perspective view showing a rough configuration of a semiconductor laser according to a first embodiment of the present invention. In Fig. 1, an n-InGaAlP cladding layer 2, an InGaAlP MQW active layer 3, a p-InGaAlP cladding layer 4, and a p-InGaP etching stopper layer 5 are stacked in turn on an n-GaAs substrate 1. Furthermore, in addition to a p-InGaAlP ridge-stripe optical waveguide layer 6, a p-InGaAlP ridge-stripe 6a is formed on the p-InGaP etching stopper layer 5. Still furthermore, an n-GaAs current blocking layer 7 is formed so as to cover the p-InGaAlP ridge-stripe 6a on both sides of the p-InGaAlP ridge-stripe optical waveguide layer 6. A p-GaAs contact layer 8 is formed on the p-InGaAlP ridge-stripe optical waveguide layer 6 and the n-GaAs current blocking layer 7.

These layers may be formed by means of, for instance, MOCVD (metal-organic chemical vapor deposition), MBE (molecular beam epitaxy), or ALE (atomic layer epitaxy).

A p-side electrode 9 and a solder layer 10 are formed on the p-GaAs contact layer 8, and an n-side electrode 11 is formed on a rear surface of the n-GaAs substrate 1.

Furthermore, an optical waveguide swelling 13 corresponding to the p-InGaAlP ridge-stripe optical waveguide layer 6 and a non-optical-waveguide swelling 13a corresponding to the p-InGaAlP ridge-stripe 6a are formed on the laser-stripe surface where the solder layer 10 is formed.

Whereas the n-GaAs current blocking layer 7 is not formed on the p-InGaAlP ridge-stripe optical waveguide layer 6, it is formed on the p-InGaAlP ridge-stripe 6a. As a result, the non-optical-waveguide swelling 13a is higher than the optical waveguide swelling 13 by approximately 1 µm.

Furthermore, a front reflective coating 12a and a rear reflective coating 12b are formed on resonator end faces, and these front reflective coating 12a and rear reflective coating 12b go around to top and bottom faces of the chip. As a result, a front reflective coating extension 14 of the width of approximately ten plus several micrometers is formed. In order to efficiently take out forward exit light, reflectance of the rear reflective coating 12b may be made higher than that of the front reflective coating 12a.

A current supplied from the p-side electrode 9 flows through the p-GaAs contact layer 8 to the p-InGaAlP ridge-stripe optical waveguide layer 6 and is injected into the InGaAlP MQW active layer 3 under the p-InGaAlP ridge-stripe optical waveguide layer 6, and laser oscillation occurs in this region. The n-GaAs current blocking layers 7 are formed on both sides of the p-InGaAlP ridge-stripe optical waveguide layer 6, and the current does not flow through the n-GaAs current blocking layers 7. As a result, the current may be efficiently injected into the InGaAlP MQW active layer 3 under the p-InGaAlP ridge-stripe optical waveguide layer 6, and, thereby, the threshold current may be lowered.

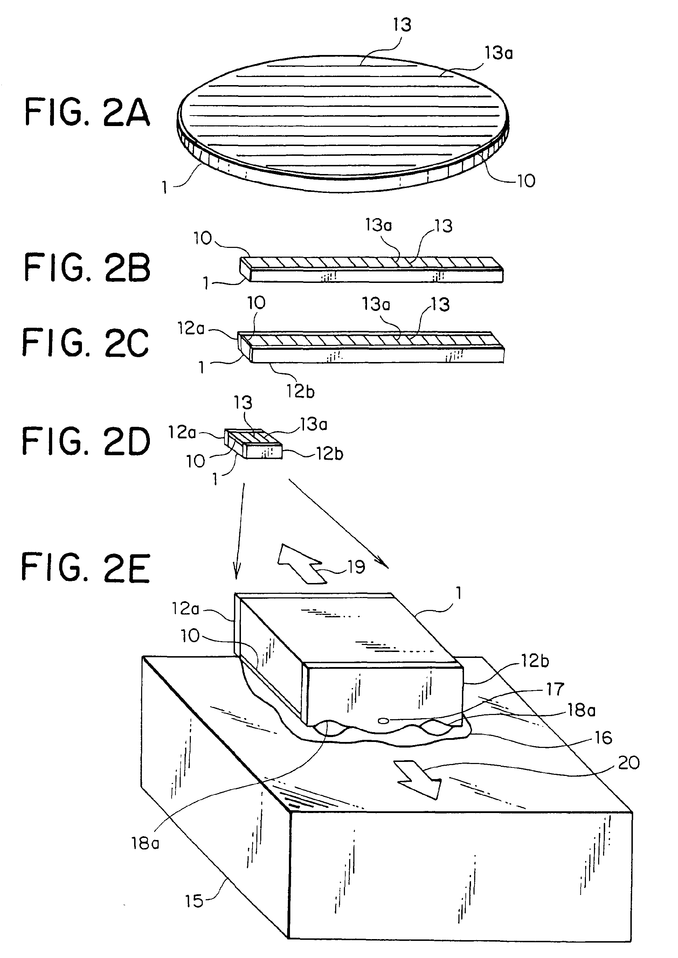

Figs. 2A through 2E are perspective views showing the sequence of a mounting process of a semiconductor laser according to the first embodiment of the present invention. When the solder layer 10 is formed on the wafer-like substrate 1, as shown in Fig. 2A, the wafer-like substrate 1 is cleaved, as shown in Fig. 2B. Thereby, the wafer-like substrate 1 is cut into bars, and resonator faces are formed on a cleaved facet. The non-optical-waveguide swelling 13a, as well as the optical waveguide swelling 13, is formed on the laser-stripe surface where the solder layer 10 is formed.

Next, cleaved bar-like substrates 1 are stacked up/down, and sputtering is implemented onto the cleaved facets. Thereby, the front reflective coating 12a and the rear reflective coating 12b are formed on the cleaved facets, as shown in Fig. 2C.

Next, the bar-like substrate 1 is scribed into chips as shown in Fig. 2D, thereby semiconductor laser chips are formed.

Next, the semiconductor laser chip is mounted on the heatsink 15, with the laser-stripe surface where the optical waveguide swelling 13 and the non-optical-waveguide swellings 13a are formed directed downward, as shown in Fig. 2E. Then, the semiconductor laser chip is heated while pressing down it by means of the collet. Thereby, the semiconductor laser chip is solderd through the solder layer 10 onto the heatsink 15.

When the semiconductor laser chip is solderd under heating and pressurizing, the solder layer 10 is melted and flows outside. As a result, the rear reflective coating 12b suffers compressive stress through the reflective coating extension 14. However, the non-optical-waveguide swellings 13a, which are higher than the optical waveguide swelling 13, are formed on the laser stripe surface of the semiconductor laser chip. Accordingly, the semiconductor chip may be supported by the non-optical-waveguide swellings 13a, while keeping the optical waveguide swelling 13 from coming into contact with the heatsink 15, even when the semiconductor chip is mounted on the heatsink 15 with the laser-stripe surface where the optical waveguide swelling 13 is formed directed downward.

As a result, the compressive stress on the rear reflective coating 12b may be concentrated on the non-optical-waveguide swellings 13a, and, thereby, the optical waveguide swelling 13 may be suppressed from suffering the compressive stress. As a result, it may be possible that the peeling 18a of the reflective coating 12b may be caused to occur at a position distant from the emitting point 17, and, thereby, not to occur in the neighborhood of the emitting point 17. Accordingly, the reflectance may be prevented from varying at the emitting point 17, and deterioration of manufacturing yield due to the monitor signal intensity failure may be reduced.

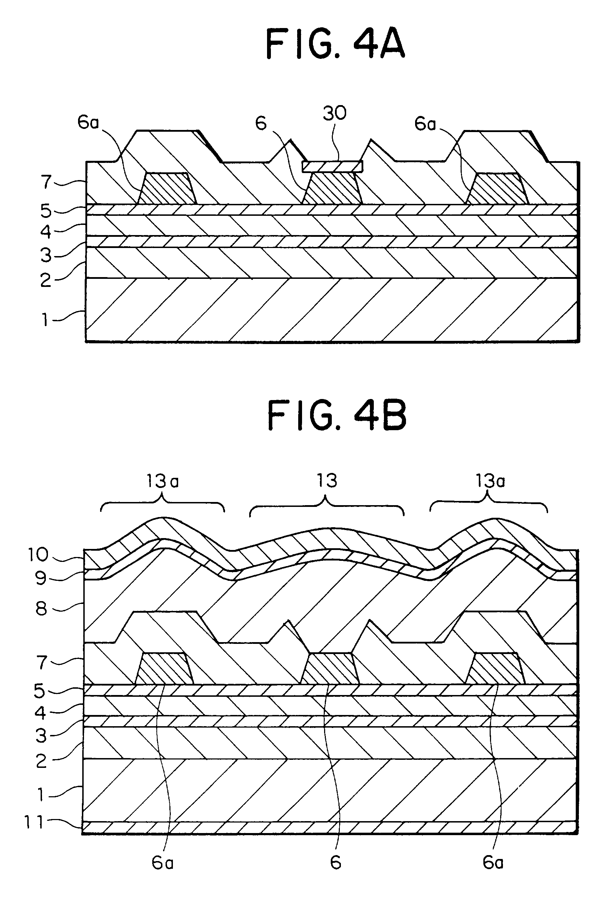

Figs. 3A through 3C, and Figs. 4A and 4B are sectional views showing the sequence of a fabricating process of a semiconductor laser according to a first embodiment of the present invention.

An n-InGaAlP cladding layer 2, an InGaAlP MQW active layer 3, a p-InGaAlP cladding layer 4, a p-InGaP etching stopper layer 5, and a p-InGaAlP layer 6 are stacked in turn on an n-GaAs substrate 1, by means of MOCVD or the like, as shown in Fig. 3A.

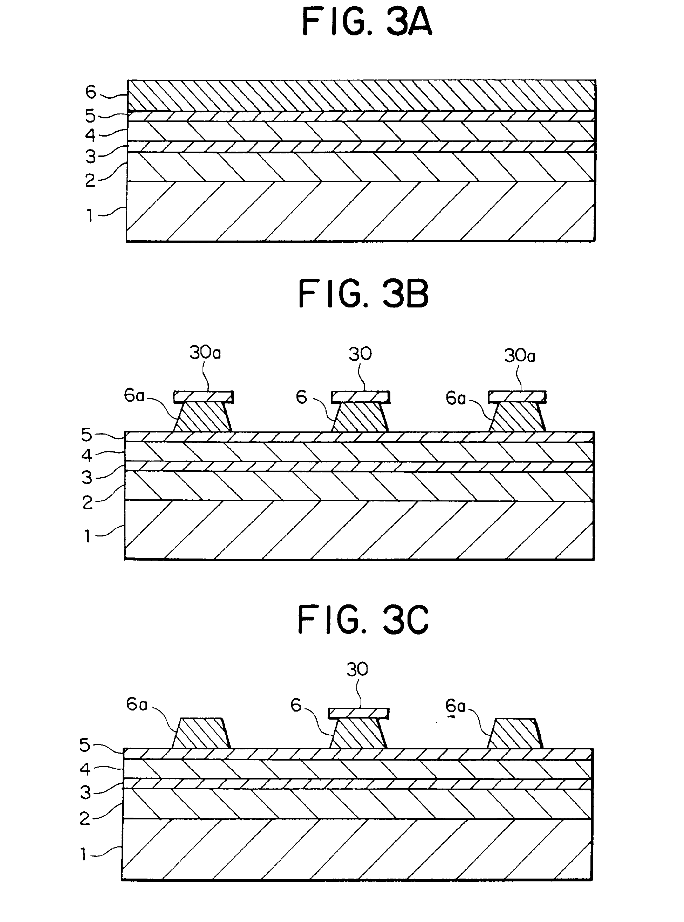

Next, a silicon oxide film (dielectrics film) is formed over an entire surface by means of CVD or sputtering, and, the silicon oxide film is patterned by use of lithography techniques and etching techniques, as shown in Fig. 3B. Thereby, in addition to a silicon oxide film 30 corresponding to the p-InGaAlP ridge-stripe optical waveguide layer 6, silicon oxide films 30a corresponding to the p-InGaAlP ridge-stripes 6a are formed.

Then, etching is implemented with these silicon oxide films 30, 30a as masks. Thereby, the p-InGaAlP ridge-stripe optical waveguide layer 6 and the p-InGaAlP ridge-stripe 6a are formed. The p-InGaP etching stopper layer 5 is formed under the p-InGaAlP layer 6, and, thereby, a etching ratio of the p-InGaAlP layer 6 to the p-InGaP etching stopper layer 5 can be made large. As a result, the etching of the p-InGaAlP layer 6 may be stopped at the position of the p-InGaP etching stopper layer 5, even when a etching ratio of the p-InGaAIP cladding layer 4 to the p-InGaAlP layer 6 is small. Accordingly, the p-InGaAlP ridge-stripe optical waveguide layer 6 and the p-InGaAlP ridge-stripes 6a may be formed with high precision.

Next, the silicon oxide films 30a on the p-InGaAIP ridge-stripes 6a are removed by use of lithography techniques and etching techniques, as shown in Fig. 3C.

Then, n-GaAs current blocking layers 7 are formed by means of MOCVD or the like, while leaving the silicon oxide film 30 on the p-InGaAlP ridge-stripe optical waveguide layer 6, as shown in Fig. 4A. Since the n-GaAs current blocking layer 7 is not formed on the silicon oxide film 30, the n-GaAs current blocking layers 7 may be formed on both sides of the p-InGaAlP ridge-stripe optical waveguide layer 6 so as to cover the p-InGaAlP ridge-stripes 6a. Accordingly, the swellings of the n-GaAs current blocking layers 7 on the p-InGaAlP ridge-stripes 6a may be made higher than the swellings at both sides of the p-InGaAlP ridge-stripe optical waveguide layer 6, when the n-GaAs current blocking layers 7 are formed.

Then, the silicon oxide film 30 on the p-InGaAlP ridge-stripe optical waveguide layer 6 is removed, and, a p-GaAs contact layer 8 is formed by means of MOCVD or the like, as shown in Fig. 4B. The n-GaAs substrate 1 is polished to the thickness of substantially 100 µm to make easier to cleave. Ap-side electrode 9 and a solder layer 10 are formed on the p-GaAs contact layer 8, and an n-side electrode 11 is formed on a rear surface of the n-GaAs substrate 1, by means of sputtering or vapor deposition.

Thus, in the aforementioned embodiment, the non-optical-waveguide swellings 13a higher than the optical waveguide swelling 13 may be formed on the laser-stripe surface, by changing only the patterning process in the formation of the ridge-stripe optical waveguide layer 6. Thereby, the yield when mounting the semiconductor chip may be improved.

In the above embodiment, the non-optical-waveguide swellings 13a are formed in stripe on both sides of the optical waveguide swelling 13 so that the optical waveguide swelling 13 may not come into contact with the heatsink 15 when mounting the semiconductor laser chip on the heatsink 15. However, the non-optical-waveguide swelling 13a, without restricting to forming into stripe, may be formed into various shapes considering heat dissipation properties and reliability.

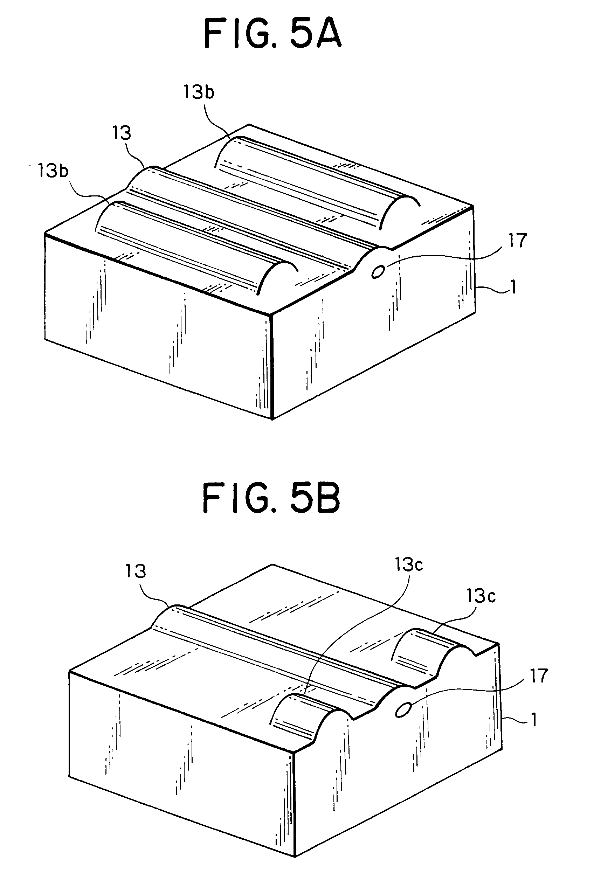

Fig. 5A is a perspective view showing a rough configuration of a semiconductor laser according to a second embodiment of the present invention. In Fig. 5A, stripe-like non-optical-waveguide swellings 13b, higher than an optical waveguide swelling 13, are formed on both sides of the optical waveguide swelling 13 so as not to approach cleaved facets of the semiconductor laser chip.

Thereby, all portions of the reflective coatings 12a and 12b may be relieved from suffering the compressive stress, even when the semiconductor laser chip is mounted on the heatsink 15 with the laser stripe surface directed downward. As a result, not only the peeling 18 of the reflective coating 12b in Fig. 9E, but also the peeling 18a of the reflective coating 12b in Fig. 2E may be suppressed, and, thereby, the cleaved facets may be suppressed from being corroded. As a result, reliability of the semiconductor laser may be furthermore improved.

Fig. 5B is a perspective view showing a rough configuration of a semiconductor laser according to a third embodiment of the present invention. In Fig. 5B, stripe-like non-optical-waveguide swellings 13c, higher than an optical waveguide swelling 13, are formed only on an reflective coating 12b side.

The semiconductor laser chip is mounted on the heatsink 15 with a fore portion thereof protruded from the heatsink 15, as shown in Fig. 2E, so that forward exit light 19 (Fig. 2E), suppressed from being reflected by the heatsink 15 and thereby from interfering with a main beam, may form a clear far-field image.

In such mounting method, the front reflective coating 12a does not suffer the compressive stress, also when soldering is applied on the semiconductor chip under heating and pressurizing. Accordingly, there hardly occurs the peeling of the front reflective coating 12a.

Therefore, the protecting film may be suppressed from peeling in the neighborhood of the emitting point 17, also in case the stripe-like non-optical-waveguide swelling 13c is formed only on the reflective coating 12b side.

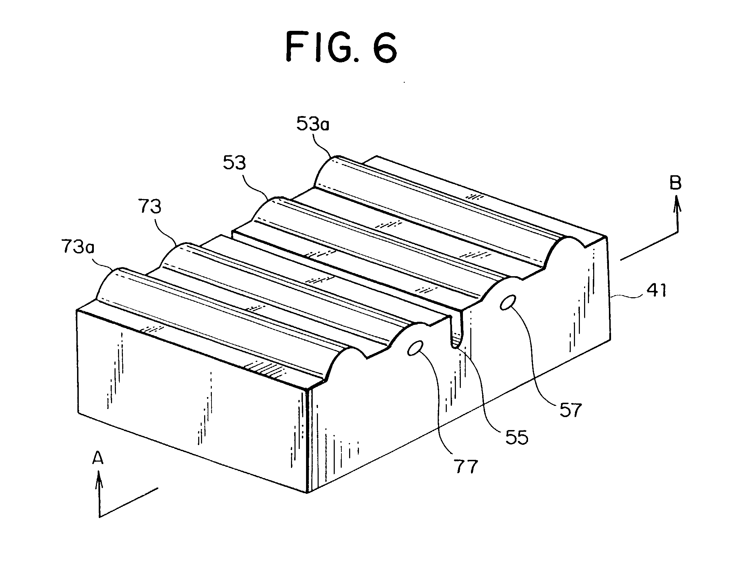

Fig. 6 is a perspective view showing a rough configuration of a semiconductor laser according to a fourth embodiment of the present invention. In the fourth embodiment, the peeling suppression of the protecting film in the neighborhood of the emitting point is applied to a two-wavelength semiconductor laser.

In Fig. 6, a 650 nm wavelength emitting point 57 and a 780 nm wavelength emitting point 77 are disposed on an n-GaAs substrate 41, and, optical waveguide swellings 53 and 73 are formed on the n-GaAs substrate 41, respectively corresponding to these emitting points 57 and 77.

Stripe-like non-optical-waveguide swellings 53a and 73a, higher than optical waveguide swellings 53 and 73, are formed on both sides of the optical waveguide swellings 53 and 73, respectively. Thereby, the optical waveguide swellings 53 and 73 may be made not to come into contact with the heatsink, even when mounting on the heatsink with the laser stripe surface directed downward. The protecting film may be suppressed from peeling in the neighborhood of the emitting points 57 and 77, also when there are a plurality of emitting points 57 and 77.

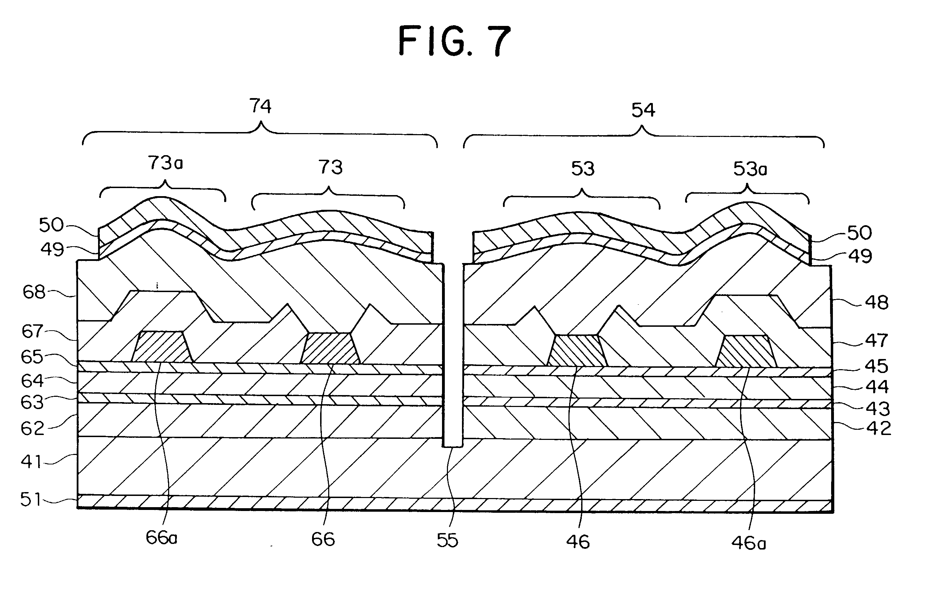

Fig. 7 is a sectional view cut along a A-B line in Fig. 6. In Fig. 7, n-InGaAlP cladding layers 42 and 62 are formed on the n-GaAs substrate 1; an InGaAlP MQW active layer 43 in a 650 nm wavelength region 54; and an AlGaAs MQW active layer 63 in a 780 nm wavelength region 74.

Furthermore, a p-InGaAlP cladding layer 44 and a p-InGaP etching stopper layer 45, and a p-InGaAlP cladding layer 64 and a p-InGaP etching stopper layer 65 are stacked on the InGaAlP MQW active layer 43 and the AlGaAs MQW active layer 63, respectively. Furthermore, in addition to p-InGaAlP ridge-stripe optical waveguide layers 46 and 66, p-InGaAlP ridge-stripes 46a and 66a are formed on each of the p-InGaP etching stopper layers 45 and 65. In addition, n-GaAs current blocking layers 47 and 67 are formed on both sides of the p-InGaAlP ridge-stripe optical waveguide layers 46 and 66 so as to cover each of the p-InGaAlP ridge-stripes 46a and 66a. P-GaAs contact layers 48 and 68 are formed on each of the p-InGaAlP ridge-stripe optical waveguide layers 46 and 66 and the n-GaAs current blocking layers 47 and 67.

P-side electrodes 49 and solder layers 50 are formed on the p-GaAs contact layers 48 and 68, respectively, and, an n-side electrode 51 is formed on the rear surface of the n-GaAs substrate 41.

The 650 nm wavelength region 54 and the 780 nm wavelength region 74 are separated by an isolation trench 55.

Furthermore, the optical waveguide swellings 53 and 73 corresponding, respectively, to the p-InGaAlP ridge-stripe optical waveguide layers 46 and 66, and, the non-optical-waveguide swellings 53a and 73a corresponding, respectively, to the p-InGaAlP ridge-stripe 46a and 66a, are formed on the laser-stripe surfaces where the solder layers 50 are formed.

In each of the aforementioned embodiments, methods, in which larger swellings are formed in the surroundings of the optical waveguide swellings 13, 53, and 73, so that these optical waveguide swellings may be suppressed from coming into contact with the heatsink 15, are explained. These optical waveguide swellings 13, 53, and 73, however, may be made by scraping off by means of etching or the like.

It is understood that the invention is not confined to the particular embodiments set forth herein as illustrative, but embraces all such modified forms thereof as come within the scope of the following claims.

## Claims

1. A semiconductor laser, comprising:
a laser-stripe portion;
a first site in a swelled shape on the laser-stripe portion; and
a second site, disposed in the surroundings of the first site, having a swelled shape higher than the first site.

2. A semiconductor laser, comprising:
a substrate;
a surface on a side opposite to the substrate;
a laser-stripe portion formed on the substrate;
resonator surfaces formed at both ends of the laser-stripe portion; and
a site, disposed in a neighborhood of at least one of the resonator surfaces, swelling up to a position higher than a height of a upper portion of the laser-stripe portion which upper portion is the surface on the side opposite to the substrate.

3. A semiconductor laser, comprising:
a first conductivity type substrate;
a first conductivity type cladding layer formed on the first conductivity type substrate;
an active layer formed on the first conductivity type cladding layer;
a second conductivity type cladding layer formed on the active layer;
a second conductivity type ridge-stripe optical waveguide formed on the second conductive cladding layer; and
a second conductivity type protrusion formed on the second conductivity type cladding layer and disposed in a region other than the second conductivity type ridge-stripe optical waveguide.

4. A semiconductor laser as set forth in claim 3:
wherein the second conductivity type protrusion is a second conductivity type ridge-stripe disposed in parallel with the second conductivity type ridge-stripe optical waveguide.

5. A semiconductor laser as set forth in claim 4:
wherein the second conductivity type protrusion is shorter in its stripe length than that of the second conductivity type ridge-stripe optical waveguide.

6. A semiconductor laser as set forth in claim 3, further comprising:
a first conductivity type current blocking layer formed on the second conductivity type cladding layer so as to cover the second conductivity type protrusion and disposed in a region other than the second conductivity type ridge-stripe optical waveguide.

7. A semiconductor laser as set forth in claim 3, further comprising:
a front reflective coating for protecting at least one end of the second conductivity type ridge-stripe optical waveguide; and
a rear reflective coating that protects at least the other end of the second conductivity type ridge-stripe optical waveguide and is higher in reflectance than the front reflective coating.

8. A semiconductor laser as set forth in claim 3:
wherein the first conductivity type substrate is formed of GaAs;
the cladding layers are formed of InGaAlP; and
the active layer is formed in an InGaAlP system multiple quantum well structure.

9. A method of fabricating a semiconductor laser, comprising:
forming a first conductivity type cladding layer on a first conductivity type substrate;
forming an active layer on the first conductivity type cladding layer;
forming a second conductivity type cladding layer on the active layer;
forming a second conductivity type semiconductor layer on the second conductivity type cladding layer;
patterning to form a dielectrics film on the second conductivity type semiconductor layer;
forming a second conductivity type ridge-stripe optical waveguide and a second conductivity type protrusion on the second conductivity type cladding layer by etching the second conductivity type semiconductor layer with the patterned dielectrics film as a mask;
removing the patterned dielectrics film that is formed on the second conductivity type protrusion;
stacking a first conductivity type semiconductor layer with the patterned dielectrics film that is formed on the second conductivity type ridge-stripe optical waveguide, as a mask; and
stacking a second conductivity type contact layer after removing the patterned dielectrics film that is formed on the second conductivity type ridge-stripe optical waveguide.

10. A method of mounting a semiconductor laser that comprises a substrate; a surface on a side opposite to the substrate; a laser-stripe portion formed on the substrate; resonator surfaces formed at both ends of the laser-stripe portion; and a site disposed in a neighborhood of at least one of the resonator surfaces and swelling up to a position higher than a height of a upper portion of the laser-stripe portion which upper portion is the surface on the side opposite to the substrate, on a laser chip mounting surface, the method comprising:
positioning the surface on the side opposite to the substrate facing to the laser chip mounting surface; and
fixing the positioned state.
